## Europäisches Patentamt

## European Patent Office

## Office européen des brevets

(19)

(11) Veröffentlichungsnummer: **0 249 646**
**B1**

(12)

# EUROPÄISCHE PATENTSCHRIFT

(45) Veröffentlichungstag der Patentschrift:
28.02.90

(21) Anmeldenummer: **86108288.1**

(22) Anmeldetag: **18.06.86**

(51) Int. Cl.⁴: **H05K 7/14,** H05K 3/36,
H01R 9/09

(54) **Leiterplattenanschlussklemme.**

(43) Veröffentlichungstag der Anmeldung:
**23.12.87 Patentblatt 87/52**

(45) Bekanntmachung des Hinweises auf die Patenterteilung:
**28.02.90 Patentblatt 90/9**

(84) Benannte Vertragsstaaten:
**CH DE FR GB IT LI**

(56) Entgegenhaltungen:
**DE-C- 3 423 650**
**GB-A- 2 025 161**
**US-A- 4 082 407**
**US-A- 4 577 402**

(73) Patentinhaber: **C.A. Weidmüller GmbH & Co.,**
**Postfach 950 Paderborner Strasse 175,**
**D-4930 Detmold 14(DE)**

(72) Erfinder: **Lembcke, Wolfgang, Lange Reine 72,**
**D-2801 Krummesse(DE)**

(74) Vertreter: **Loesenbeck, Karl-Otto, Dipl.-Ing. et al,**
**Jöllenbecker Strasse 164, D-4800 Bielefeld 1(DE)**

ACTORUM AG

## Beschreibung

Die Erfindung betrifft eine Leiterplattenanschlußklemme mit einem Gehäuse, in dem ein Leiteranschluß und ein an eine Leiterbahn der Leiterplatte anschließbare Stromschiene angeordnet sind. Derartige Klemmen sind beispielsweise aus der DE-AS 27 36 620 oder der DE-PS 34 23 650 bekannt. Bei derartigen bekannten Klemmen wird die Stromschiene mittels an ihr vorgesehener Lötfahnen an der betroffenen Leiterbahn der Leiterplatte festgelegt, wozu die Lötfahnen durch die Leiterplatte hindurchgesteckt werden und das Verlöten mit einer Leiterbahn auf der der Klemme abgewandt liegenden Leiterplattenfläche erfolgt. Eine mechanische Befestigungsmöglichkeit für das Gehäuse an der Leiterplatte und gegebenenfalls anderer Gegenstände ist nicht vorgesehen.

In vielen Anwendungsfällen besteht nun das Erfordernis, abständig von einer beispielsweise mit Halbleiterteilen und vergleichbaren Bauelementen bestückten Leiterplatte einen Kühlkörper zur Abführung der von den Bauelementen erzeugten Wärme festzulegen. Dabei kann auch der Kühlkörper mit Bauelementen bestückt sein. Eine vergleichbare Problematik ist auch dann gegeben, wenn abständig zu einer Leiterplatte eine weitere Leiterplatte in definierter Form mechanisch festgelegt werden soll. In derartigen Anwendungsfällen wird bislang mit besonderen Distanz- und Klemmstücken gearbeitet, die zwischen den beiden Leiterplatten und der Leiterplatte und dem Kühlkörper angeordnet und hier mechanisch befestigt werden. Bezüglich der elektrischen Verbindung zwischen der Leiterplattenanschlußklemme und der Leiterplatte besteht ferner in zunehmendem Maße das Erfordernis, die Klemme auch auf einer einseitig bedruckten Leiterplatte, auf der auch nur einseitig montierbare Bauelemente angeordnet werden, festzulegen, wozu die bislang bekannte elektrische Verbindungstechnik mit den Lötfahnen unbrauchbar ist, da in einem solchen Fall ja das Gehäuse das Erstellen einer Lötverbindung auf der dem Gehäuse zugewandt liegenden Leiterplattenfläche verhindert.

Der vorliegenden Erfindung liegt von daher die Aufgabe zugrunde, eine Leiterplattenanschlußklemme zu schaffen, die sowohl bei dem Erfordernis der abständigen Festlegung eines Kühlkörpers oder einer weiteren Leiterplatte im Verhältnis zu der vorgegebenen Leiterplatte, wie auch für die elektrische Kontaktierung einer nur einseitig beschichteten Leiterplatte einsetzbar ist.

Die erfindungsgemäße Lösung besteht darin, daß das Gehäuse der Leiterplattenanschlußklemme Aufnahmen für Befestigungselemente aufweist, mit deren Hilfe es mit einander gegenüberliegenden Anlageflächen, erforderlichenfalls unter Zwischenlage von Distanzstücken, einerseits an der Leiterplatte und andererseits an einem Kühlkörper oder einer weiteren Leiterplatte mechanisch befestigbar ist und daß die Stromschiene ein Kontaktstück zur direkten Kontaktierung einer auf der zugewandten Leiterplattenfläche befindlichen Leiterbahn aufweist.

Dank der ihr somit zugeordneten Mehrfachfunktion hat eine derartige Leiterplattenanschlußklemme den angestrebten universellen Einsatzbereich. Sie kann durch die entsprechende Gehäuseausgestaltung mit den Aufnahmen und den Anlageflächen für die mechanische, definiert abständige Festlegung eines Kühlkörpers oder einer weiteren Leiterplatte an der Bezugsleiterplatte benutzt werden, so daß hier die üblichen gesonderten Distanzstücke in Fortfall kommen. Die Ausgestaltung des mechanischen Befestigungssystemes ermöglicht den problemlosen Einsatz von Distanzstücken, so daß man bezüglich der Abstände zwischen den beiden Leiterplatten oder der Leiterplatte und dem Kühlkörper je nach Bauhöhe der auf der Leiterplatte oder dem Kühlkörper befindlichen Bauelemente die gewünschte Variabilität hat. In zweckmäßiger weiterer Ausgestaltung könnten die Aufnahmen im Gehäuse einfache Durchgangsbohrungen für Spannschrauben sein, mit denen die beiden Leiterplatten oder die Leiterplatte und der Kühlkörper dann miteinander unter Zwischenlage des Gehäuses der Klemme, gegebenenfalls ein oder mehrerer Distanzstücke, verspannt werden.

Die elektrische Kontaktierung zwischen der Stromschiene der Klemme und der betroffenen Leiterbahn der bezogenen Leiterplatte ist denkbar einfach. Insbesondere ermöglicht das Kontaktstück an der Stromschiene die Kontaktierung der Leiterbahnen von nur einseitig beschichteten Leiterplatten. Besonders einfach wird die Ausgestaltung dann, wenn man die mechanische Festlegung der beiden Leiterplatten oder der Leiterplatte und des Kühlkörpers und des Klemmengehäuses zugleich auch zur elektrischen Kontaktierung benutzt, was sich gemäß einer bevorzugten Ausführungsform dadurch erreichen läßt, daß das Kontaktstück ein an der Stromschiene vorgesehener abgewinkelter Federarm ist, der so angeordnet ist, daß er bei dieser Festlegung federnd an die betroffene Leiterbahn auf der zugewandt liegenden Leiterplattenfläche angedrückt wird. Gemäß einer weiteren Ausgestaltung ist das Kontaktstück eine an der Stromschiene vorgesehene abgewinkelte Kontaktlasche mit einer Gewindebohrung für eine Klemmschraube, mit deren Hilfe dann die Kontaktlasche fest gegen die betroffene Leiterbahn gezogen werden kann.

Ausführungsbeispiele von Leiterplattenanschlußklemmen gemäß der Erfindung werden nachstehend unter Bezugnahme auf die Zeichnung näher beschrieben. Es zeigen

Figur 1 eine zwischen einer Leiterplatte und einem Kühlkörper angeordnete Leiterplattenanschlußklemme gemäß der Erfindung in stark schematisierter Schnittdarstellung,

Figur 2 eine weitere Ausführungsform einer Leiterplattenanschlußklemme gemäß der Erfindung in stark schematisierter Schnittdarstellung,

Figur 3 eine weitere Ausführungsform einer Leiterplattenanschlußklemme gemäß der Erfindung in stark schematisierter Schnittdarstellung.

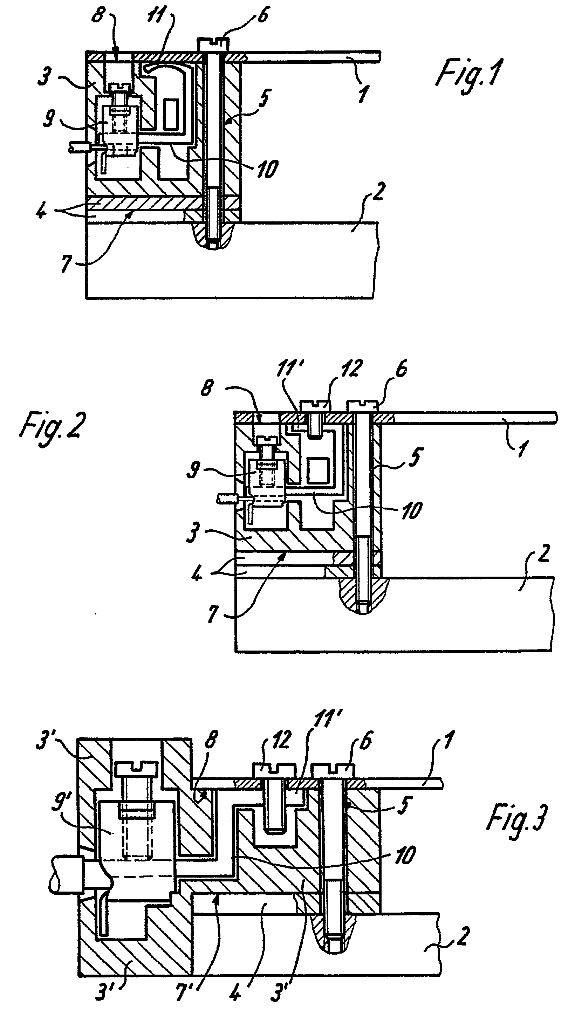

Bei dem Ausführungsbeispiel nach Figur 1 ist zwischen einer Leiterplatte 1 und einem Kühlkörper 2, der in definiertem Abstand von der Leiterplatte 1 mechanisch festzulegen ist, eine Leiterplattenanschlußklemme mit ihrem Gehäuse 3 festgesetzt, wobei dieses Gehäuse 3, in Kombination mit Distanzstücken 4, den gewünschten Abstand zwischen der Leiterplatte 1 und dem Kühlkörper 2 definiert, wobei Abstandsvariationen durch die Anzahl der Distanzstücke 4 erfaßt werden. Zur mechanischen Befestigung der Leiterplatte 1 und des Kühlkörpers 2 sowie des Gehäuses 3 der Leiterplattenanschlußklemme sowie gegebenenfalls der Distanzstücke 4 ist als Aufnahme für die Befestigungselemente im dargestellten Ausführungsbeispiel im Gehäuse 3 der Klemme eine Durchgangsbohrung 5 für eine Spannschraube 6 vorgesehen, die in den Kühlkörper 2 eingeschraubt werden kann. Bei diesem Ausführungsbeispiel sind ferner die Oberseite und die Unterseite des Gehäuses 3 als Anlageflächen 7 bzw. 8 ausgebildet, gegen die die Leiterplatte und im dargestellten Ausführungsbeispiel die Distanzstücke, ohne letztere der Kühlkörper direkt, mittels der Spannschraube 6 gespannt werden können.

Auf genau die gleiche Weise könnte anstelle des Kühlkörpers 2 eine weitere Leiterplatte in definiertem Abstand zur Leiterplatte 1 festgelegt werden.

In dem Gehäuse 3 der Leiterplattenanschlußklemme befindet sich als Leiteranschluß im dargestellten Ausführungsbeispiel ein Zugbügelanschluß 9, der auf einer Stromschiene 10 angeordnet ist. Die Stromschiene 10 ist dabei auf die direkte elektrische Kontaktierung einer Leiterbahn auf der der Klemme zugewandt liegenden Leiterplattenfläche der Leiterplatte 1 ausgelegt. Im dargestellten Ausführungsbeispiel hat die Stromschiene 10 hierzu ein Kontaktstück in Form eines abgewinkelten Federarmes 11, der so angeordnet ist, daß er bei der mechanischen Verspannung des Systmes aus Leiterplatte 1, Kühlkörper 2, Gehäuse 3 und gegebenenfalls Distanzstück 4 federnd an die entsprechende Leiterbahn der Leiterplatte 1 angedrückt wird.

Bei dem in Figur 2 dargestellten Ausführungsbeispiel ist bezüglich des mechanischen Befestigungssystemes der gleiche Aufbau wie beim Ausführungsbeispiel nach Figur 1 vorgesehen. Die Stromschiene 10 trägt an ihrem der Leiterplatte 1 zuweisenden Ende für die direkte Kontaktierung der entsprechenden Leiterbahn jedoch jetzt ein Kontakstück 11' in Form einer Kontaktlasche, die mit einer Gewindebohrung versehen ist, über die mit Hilfe einer Klemmschraube 12 die Kontaktlasche 11' der Stromschiene 10 fest gegen die entsprechende Leiterbahn der Leiterplatte 1 gezogen werden kann.

Bei dem in Figur 3 dargestellten Ausführungsbeispiel hat das Befestigungssystem zwischen der Leiterplatte 1 und dem Kühlkörper 2 sowie dem Gehäuse der Leiterplattenanschlußklemme grundsätzlich wieder den gleichen Aufbau, wobei allerdings nunmehr das Gehäuse 3' der Klemme, bezogen auf den Aufbau in Erstreckungsrichtung zwischen die Leiterplatte 1 und den Kühlkörper 2 hinein abgesetzt ausgebildet ist, dergestalt, daß sich oberseitig und unterseitig zurückspringende Anlageflächen 7', 8' für die Leiterplatte 1 und den Kühlkörper 2 oder an dessen Stelle gegebenenfalls eine weitere Leiterplatte befinden. Der erweiterte Bereich des Gehäuses 3', der den Zugbügelanschluß 9 beinhaltet, steht über die Leiterplatte 1 und gegebenenfalls auch den Kühlkörper 2 nach oben und unten vor und erstreckt sich auch aus dem Raum unmittelbar zwischen diesen beiden Teilen heraus. Wenn eine solche Anordnung aus Platzgründen möglich ist, hat dies den Vorteil, daß die Klemmschraube des Zugbügelanschlusses 9 in jedem Fall von oben frei zugänglich bleibt, nicht also hier noch eine gesonderte Zugangsbohrung in der Leiterplatte vorgesehen werden muß, wie dies bei den Ausführungsbeispielen nach den Figuren 1 und 2 der Fall ist.

Man ist bei dieser Ausführungsform auch im Bereich des eigentlichen Leiteranschlusses in der Dimensionierung flexibler und kann erforderlichenfalls entsprechend kräftig dimensionierte Leiteranschlußsysteme vorsehen. Dabei ist darauf hinzuweisen, daß abweichend von den dargestellten Ausführungsbeispielen auch jedwede andere bekannte Leiteranschlüsse anstelle der hier gezeigten Zugbügelanschlüsse 9 vorgesehen werden können, was für alle gezeigten Ausführungsbeispiele gilt.

## Patentansprüche

1. Leiterplattenanschlußklemme mit einem Gehäuse (3, 3'), in dem ein Leiteranschluß (9) und eine an eine Leiterbahn der Leiterplatte (1) anschließbare Stromschiene (10) angeordnet sind, **dadurch gekennzeichnet**, daß das Gehäuse (3, 3') Aufnahmen (5) für Befestigungselemente (6) aufweist, mit deren Hilfe es mit einander gegenüberliegenden Anlageflächen (7, 8; 7', 8'), erforderlichenfalls unter Zwischenlage von Distanzstücken (4) einerseits an der Leiterplatte (1) und andererseits an einem Kühlkörper (2) oder einer weiteren Leiterplatte mechanisch befestigbar ist und daß die Stromschiene (10) ein Kontaktstück (11, 11') zur direkten Kontaktierung einer auf der zugewandten Leiterplattenfläche befindlichen Leiterbahn aufweist.

2. Leiterplattenanschlußklemme nach Anspruch 1, dadurch gekennzeichnet, daß die Aufnahmen Durchgangsbohrungen (5) für Spannschrauben (6) sind, mit denen die Leiterplatte (1) und der Kühlkörper (2) oder eine weitere Leiterplatte sowie das Klemmengehäuse (3, 3'), gegebenenfalls auch die Distanzstücke (4) fest miteinander verschraubbar sind.

3. Leiterplattenanschlußklemme nach Anspruch 1 oder 2, dadurch gekennzeichnet, daß das Gehäuse (3') einen sich zwischen die Leiterplatte (1) und den Kühlkörper (2) bzw. eine weitere Leiterplatte erstreckenden, rückspringenden Abschnitt aufweist, der die Anlageflächen (7', 8') aufweist, während der den Leiteranschluß (9) beinhaltende Abschnitt des Gehäuses (3') aus dem Raum zwischen der Leiterplatte (1) und dem Kühlkörper (2) bzw. der weiteren Leiterplatte vorsteht.

4. Leiterplattenanschlußklemme nach Anspruch 1, dadurch gekennzeichnet, daß das Kontaktstück der Stromschiene (10) ein abgewinkelter Federarm (11) ist, der so angeordnet ist, daß er bei der mechanischen Festlegung des Gehäuses (3) zwischen der Leiterplatte (1) und dem Kühlkörper (2) bzw. der weiteren Leiterplatte an die Leiterbahn der Leiterplatte (1) federnd angedrückt ist.

5. Leiterplattenanschlußklemme nach Anspruch 1, dadurch gekennzeichnet, daß das Kontaktstück der Stromschiene (10) eine abgewinkelte Kontaktlasche (11') ist, die eine Gewindebohrung für eine Klemmschraube (12) aufweist, mit der sie gegen die Leiterbahn schraubbar ist.

## Claims

1. A printed circuit board connection terminal comprising a housing (3, 3') in which are arranged a conductor connection (9) and a current bar (10) which can be connected to a conductor track of the printed circuit board (1) characterised in that the housing (3, 3') has receiving means (5) for fixing elements (6) by means of which it can be mechanically fixed with mutually oppositely disposed contact surfaces (7, 8: 7', 8'), if necessary with the interposition of spacer portions (4), on the one hand to the printed circuit board (1) and on the other hand to a cooling body (2) or a further printed circuit board, and that the current bar (10) has a contact portion (11, 11') for direct contacting of a conductor track disposed on the surface of the printed circuit board which is towards same.

2. A printed circuit board connection terminal according to claim 1 characterised in that the receiving means are throughbores (5) for clamping screws (6) with which the printed circuit board (1) and the cooling body (2) or a further printed circuit board as well as the terminal housing (3, 3') and possibly also the spacer portions (4) can be fixedly screwed together.

3. A printed circuit board connection terminal according to claim 1 or claim 2 characterised in that the housing (3') has a set-back portion which extends between the printed circuit board (1) and the cooling body (2) or a further printed circuit board and which has the contact surfaces (7', 8') while the portion of the housing (3') which contains the conductor connection (9) projects out of the space between the printed circuit board (1) and the cooling body (2) or the further printed circuit board.

4. A printed circuit board connection terminal according to claim 1 characterised in that the contact portion of the current bar (10) is an angular spring arm (11) which is so arranged that, when the housing (3) is mechanically fixed between the printed circuit board (1) and the cooling body (2) or the further printed circuit board, the spring arm is resiliently pressed against the conductor track of the printed circuit board (1).

5. A printed circuit board connection terminal according to claim 1 characterised in that the contact portion of the current bar (10) is an angular contact plate (11') which has a screwthreaded bore for a clamping screw (12) with which it can be screwed against the conductor track.

## Revendications

1. Borne de raccordement à une plaquette imrimée, avec un boîtier (3, 3') dans lequel sont disposés un branchement de conducteur (9) et un rail conducteur (10) qui peut être raccordé sur une piste conductrice de la plaquette imprimée (1), caractérisée en ce que le boîter (3, 3') présente des logements (5) pour des éléments de fixation (6) à l'aide desquels le boîtier peut, par des faces d'application opposées (7, 8; 7', 8') et si nécessaire en intercalant des pièces d'écartement (4), être fixé mécaniquement d'un côté sur la plaquette imprimée (1) et de l'autre côté sur un corps de refroidissement (2) ou sur une autre plaquette imprimée, et en ce que le rail conducteur (10) présente un élément de contact (11, 11') pour réaliser un contact direct avec une piste conductrice se trouvant sur la face de la plaquette imprimée qui est tournée vers le rail conducteur.

2. Borne de raccordement à une plaquette imprimée selon la revendication 1, caractérisée en ce que logements sont des alésages traversants (5) pour des vis de serrage (6) qui permettent de visser l'un à l'autre la plaquette imprimée (1) et le corps de refroidissement (2) ou une autre plaquette imprimée, ainsi que le boîtier de borne (3, 3'), et le cas échéant que les pièces d'écartement (4).

3. Borne de raccordement à une plaquette imprimée selon la revendication 1 ou 2, caractérisée en ce que le boîtier (3') présente une partie en retrait qui s'étend entre la plaquette imprimée (1) et le corps de refroidissement (2) ou selon le cas une autre plaquette imprimée, et qui présente les faces d'application (7', 8'), tandis que la partie du boîtier (3') qui contient le branchement de conducteur (9) dépasse de l'espace entre la plaquette imprimée (1) et le corps de refroidissement (2) ou selon le cas l'autre plaquette imprimée.

4. Borne de raccordement à une plaquette imprimée selon la revendication 1, caractérisée en ce que l'élément de contact du rail conducteur (10) est un bras élastique coudé (11) qui est disposé de telle sorte que, lors de la fixation mécanique du boîtier (3) entre la plaquette imprimée (1) et le corps de refroidissement (2) ou selon le cas l'autre plaquette, il est pressé élastiquement contre la piste conductrice de la plaquette imprimée (1).

5. Borne de raccordement à une plaquette imprimée selon la revendication 1, caractérisée en ce que l'élément de contact du rail conducteur (10) est une patte de contact coudée (11'), qui présente un taraudage fileté pour une vis de serrage (12) qui permet de la visser contre la piste conductrice.

EP 0 249 646 B1

*Fig.1*

*Fig.2*

*Fig.3*